# EUROPÄISCHE PATENTSCHRIFT

(11) **EP 2 697 486 B1**
(45) Veröffentlichungstag und Bekanntmachung des Hinweises auf die Patenterteilung: **10.08.2016**
(21) Anmeldenummer: 12715052.2
(22) Anmeldetag: 10.04.2012
(51) Int. Cl.: F01N 3/04, F01N 5/02, F02G 5/02, H01L 35/30

(54) **VORRICHTUNG MIT EINEM WÄRMETAUSCHER FÜR EINEN THERMOELEKTRISCHEN GENERATOR EINES KRAFTFAHRZEUGS**
DEVICE HAVING A HEAT EXCHANGER FOR A THERMOELECTRIC GENERATOR OF A MOTOR VEHICLE
DISPOSITIF COMPRENANT UN ÉCHANGEUR DE CHALEUR POUR UN GÉNÉRATEUR THERMOÉLECTRIQUE D'UN VÉHICULE AUTOMOBILE

(30) Priorität: 13.04.2011 DE 102011016808
(43) Veröffentlichungstag der Anmeldung: 19.02.2014
(73) Patentinhaber: Continental Automotive GmbH, 30165 Hannover (DE)
(72) Erfinder: LIMBECK, Sigrid, 53804 Much (DE); BRÜCK, Rolf, 51429 Bergisch Gladbach (DE)
(86) Internationale Anmeldenummer: PCT/EP2012/056407
(87) Internationale Veröffentlichungsnummer: WO 2012/139992

(56) Entgegenhaltungen:
- EP-A1- 2 196 648
- WO-A1-96/32572
- WO-A2-2008/068632
- WO-A2-2010/057578
- JP-A- 9 036 439
- JP-A- 2000 018 095

## Beschreibung

Die vorliegende Erfindung betrifft eine Vorrichtung mit einem Wärmetauscher für einen thermoelektrischen Generator, insbesondere zur Anordnung in einem Kraftfahrzeug.

Das Abgas aus einer Verbrennungskraftmaschine eines Kraftfahrzeugs besitzt thermische Energie, welche mittels des thermoelektrischen Generators in elektrische Energie umgewandelt werden soll, bspw. um eine Batterie oder einen anderen Energiespeicher zu füllen und/oder elektrischen Verbrauchern die benötigte Energie direkt zuzuführen. Damit steht für den Betrieb des Kraftfahrzeugs Energie in größerem Umfang zur Verfügung. Durch den Einsatz eines thermoelektrischen Generators wird der energetische Wirkungsgrad einer Verbrennungskraftmaschine weiter erhöht.

Ein solcher thermoelektrischer Generator weist zumeist eine Mehrzahl, ggf. modulartiger, thermoelektrischer Wandlerelemente auf. Thermoelektrische Materialien sind von einer Art, dass diese effektiv thermische Energie in elektrische Energie umwandeln können (Seebeck-Effekt) und umgekehrt (Peltier-Effekt). Der Seebeck-Effekt basiert auf dem Phänomen der Umwandlung von Wärmeenergie in elektrische Energie und wird zur Erzeugung thermoelektrischer Energie benutzt. Der Peltier-Effekt ist die Umkehrung des Seebeck-Effekts und ein Phänomen, welches mit Wärmeadsorption einhergeht und in Relation zu einem Stromfluss durch unterschiedliche Materialen verursacht wird. Der Peltier-Effekt ist bspw. zum thermoelektrischen Kühlen bereits vorgeschlagen worden.

Solche thermoelektrischen Wandlerelemente weisen bevorzugt eine Vielzahl von thermoelektrischen Elementen auf, die zwischen einer sogenannten Warmseite und einer sogenannten Kaltseite positioniert sind. Thermoelektrische Elemente umfassen z. B. wenigstens zwei Halbleiterquader (p-dotiert und n-dotiert), die auf ihrer Ober- und Unterseite (hin zur heißen Seite bzw. kalten Seite) wechselseitig mit elektrisch leitenden Brücken verbunden sind. Keramikplatten bzw. Keramikbeschichtungen, aber auch Kunststoffe und/oder ähnliche Materialien dienen zur Isolierung der Metallbrücken und sind somit bevorzugt zwischen den Metallbrücken angeordnet. Wird ein Temperaturgefälle beidseits der Halbleiterquader bereitgestellt, so bildet sich ein Spannungspotential. Auf der einen Kontaktstelle wird dabei Wärme aufgenommen (Heißseite), wobei die Elektronen der einen Seite auf das energetisch höher liegende Leitungsband des folgenden Quaders gelangen. Auf der anderen Seite können die Elektronen nun Energie freisetzen, um wieder auf ein niedrigeres Energieniveau zu gelangen (Kaltseite). Somit kann sich bei einem entsprechenden Temperaturgefälle ein Stromfluss einstellen.

Bei der Auslegung von thermoelektrischen Generatoren und deren Einsatz in einem Kraftfahrzeug sind verschiedenste Herausforderungen zu bewältigen. Unter anderem sind innerhalb der thermoelektrischen Wandlerelemente gute Wärmeübergänge bereitzustellen, so dass die vorliegenden Temperaturunterschiede effizient zur Umwandlung in elektrische Energie umgewandelt werden können. Weiterhin ist in einem unter verschiedensten Lastbedingungen arbeitenden Abgassystem einer Verbrennungskraftmaschine ein für die thermoelektrischen Elemente geeignetes Temperaturniveau bereitzustellen. Unter diesen Gesichtspunkten ist auch die Anordnung der thermoelektrischen Elemente innerhalb einer derartigen Vorrichtung bzw. eines Abgassystems zu beachten.

Die WO-A1-2008/068632 betrifft einen Wärmetauscher mit konzentrisch zueinander angeordneten Rohren. Das innere Rohr bildet die Abgasleitung und weist ein verschließbares Ende auf. Das innere Rohr ist innerhalb eines äußeren Rohres angeordnet. An der Umfangsfläche des inneren Rohres sind Öffnungen angeordnet, so dass das Abgas bei geschlossenem Ende durch diese Löcher in das konzentrisch angeordnete äußere Rohr strömen kann. Somit ist ein Bypass gebildet. In dem Zwischenraum zwischen äußerem und innerem Rohr ist ein Wärmetauscher angeordnet.

Die WO-A2-2010/057578 offenbart einen thermoelektrischen Generator. Dieser weist Wärmetauscherrohre auf, die innen von Abgas durchströmt und außen von einem Kühlmittel überströmt werden.

Aufgabe der vorliegenden Erfindung ist es demnach, die mit Bezug auf den Stand der Technik geschilderten Probleme zumindest teilweise zu lösen. Insbesondere soll eine Vorrichtung angegeben werden, die eine hohe Effizienz bei der Umwandlung von thermischer Energie aus dem Abgas in elektrische Energie aufweist. Darüber hinaus soll die Vorrichtung einen möglichst platzsparenden Aufbau aufweisen und insbesondere zur Anordnung im Bereich des Unterbodens eines Kraftfahrzeugs geeignet sein. Weiterhin soll auch ein nachträglicher Einbau der Vorrichtung in ein Kraftfahrzeug möglich sein, ohne dass aufwendige Maßnahmen zur Integration erforderlich sind.

Diese Aufgaben werden mit einer Vorrichtung gemäß den Merkmalen des Patentanspruchs 1 gelöst. Vorteilhafte Ausgestaltungen der erfindungsgemäßen Vorrichtung sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen, wie in den beigefügten Ansprüchen definiert. Die Beschreibung, insbesondere im Zusammenhang mit den Figuren, erläutert die Erfindung weiter und führt ergänzende Ausführungsbeispiele der Erfindung an.

Die Vorrichtung hat einen Wärmetauscher, insbesondere zur Anordnung in einer Abgasanlage einer Verbrennungskraftmaschine in einem Kraftfahrzeug, der zumindest ein Gehäuse mit entlang einer axialen Richtung angeordnetem Einlass an einer ersten Stirnseite und einem Auslass an einer zweiten (gegenüberliegenden) Stirnseite für ein Fluid aufweist. Weiter weist der Wärmetauscher zumindest ein äußeres Mantelrohr und ein konzentrisch dazu angeordnetes inneres Mantelrohr auf und ein sich an den Einlass (unmittelbar) anschließenden ringförmigen ersten Kanal und einen (unmittelbar) stromaufwärts von dem Auslass angeordneten ringförmigen zweiten Kanal. Der erste Kanal und der zweite Kanal sind durch eine Vielzahl von Strömungspfaden für das Fluid verbunden, die sich in einem (ringförmigen) Zwischenraum zwischen dem inneren Mantelrohr und dem äußeren Mantelrohr in der axialen Richtung erstrecken. In der Vielzahl von Strömungspfaden ist jeweils mindestens ein Wärmetauscherrohr angeordnet. Das Fluid strömt somit über den Einlass in den ringförmigen ersten Kanal ein und wird anschließend über die Vielzahl von Strömungspfaden hin zum ringförmigen zweiten Kanal geführt. Das Fluid verlässt das Gehäuse anschließend über den Auslass.

Das Gehäuse, bzw. das innere und/oder äußere Mantelrohr, ist bevorzugt rund, insbesondere kreisförmig oder auch elliptisch/oval geformt, aber keineswegs auf eine solche Form beschränkt. Der Zwischenraum, der die Strömungspfade umschließt, wird durch das äußere Mantelrohr und das innere Mantelrohr gebildet. Das innere Mantelrohr umschließt einen Hohlraum. Der Einlass und der Auslass sind insbesondere zylindrisch und mit der Abgasleitung einer Verbrennungskraftmaschine verbunden. Aus der Abgasleitung strömt das Fluid (z. B. ein Abgas der Verbrennungskraftmaschine) in den ringförmigen ersten Kanal und wird durch diesen in den (ringförmigen) Zwischenraum zwischen äußerem und innerem Mantelrohr überführt. Insbesondere umgibt der ringförmige erste Kanal zumindest teilweise den Einlass. Der erste Kanal kann aber auch zylindrisch ausgeführt sein und sich unmittelbar an den Einlass anschließen, so dass das Fluid über den ersten Kanal in den ringförmigen Zwischenraum einströmt.

Gemäß einer bevorzugten Ausgestaltung der Vorrichtung weist zumindest ein Strömungspfad kein Wärmetauscherrohr auf. Dieser Strömungspfad dient damit als Bypass, der durch ein Regelelement, das z. B. in dem ersten ringförmigen Kanal und/oder in dem Einlass angeordnet ist, mit dem Fluid beaufschlagt werden kann. Bevorzugt kann der gesamte Fluidstrom über diesen Bypass an den Wärmetauscherrohren vorbeigeführt werden. Dies ist insbesondere dann erforderlich, wenn die Abgastemperatur zu hoch ist, so dass die Wärmetauscherrohre nicht ausreichend gekühlt werden können, bzw. wenn eine Kühlmittelversorgung nicht zusätzlich belastet werden soll. Weiterhin kann somit auch der Wärmeeintrag an stromabwärts angeordneten Abgasbehandlungskomponenten gesteuert werden, indem nur ein regelbarer Wärmeverlust durch die Überströmung der Wärmetauscherrohre erfolgt. Die thermische Energie bleibt also im Fluid gespeichert und wird erst stromabwärts des Wärmetauschers an zusätzlich angeordnete Abgasbehandlungskomponenten in einer Abgasleitung abgegeben. Die Kontrolle und/oder Einstellung der Durchströmung des Bypass erfolgt bevorzugt unter Berücksichtigung des Betriebspunktes der Verbrennungskraftmaschine bzw. unter Berücksichtigung von Kennwerten des Fluids (Temperatur, Druck, Fluidzusammensetzung).

Gemäß einer vorteilhaften Ausgestaltung der Vorrichtung sind thermoelektrische Elemente in den Wärmetauscherrohren vorgesehen. Die thermoelektrischen Elemente sind dabei insbesondere ringförmig in der axialen Richtung des Wärmetauscherrohrs aufeinander gestapelt. Die Wärmetauscherrohre werden außen von dem heißen Fluid (Abgas) überströmt und durch einen inneren Kanal von einem Kühlfluid (Wasser) durchströmt. Durch den so entstehenden Temperaturgradienten zwischen der Außenfläche und einem innerem Kanal des Wärmetauscherrohrs wird durch die elektrisch verschalteten thermoelektrischen Elemente ein elektrischer Strom erzeugt, der am Gehäuse des Wärmetauschers über geeignete elektrische Anschlüsse abgegriffen werden kann. Die Vorrichtung mit dem Wärmetauscher wird somit als thermoelektrischer Generator betrieben, der insbesondere mit elektrischen Speichern oder elektrischen Verbrauchern des Kraftfahrzeugs verbunden ist, so dass hierbei der durch den thermoelektrischen Generator erzeugte Strom dem Kraftfahrzeug zur Verfügung gestellt werden kann.

Als thermoelektrische Materialien für die thermoelektrischen Elemente kommen insbesondere die Folgenden in Frage:
n-dotiertes thermoelektrisches Material: Silicide (z. B. MgSi-MgSn)
p-dotiertes thermoelektrisches Material: Zintl-Phasen (z. B. Zn₄Sb₄)

Diese Materialien haben sich als besonders vorteilhaft erwiesen und ermöglichen eine effiziente Umwandlung der thermischen Energie des heißen Fluids (Abgas) in elektrische Energie. Bei den Siliciden handelt es sich insbesondere um binäre metallische Verbindungen des Siliciums, die als Halbleiter genutzt werden können. Bei den Zintl-Phasen handelt es sich insbesondere um intermetallische Verbindungen zwischen stark elektropositiven Alkalimetallen oder Erdalkalimetallen und mäßig elektronegativen Elementen aus der 13. bis 16. Gruppe des Periodensystems. Einige Zintl-Phasen sind diamagnetische Halbleiter, deren Leitfähigkeit im Gegensatz zu metallischen Leitern mit steigender Temperatur ansteigt.

Erfindungsgemäß weist das innere Mantelrohr und/oder das äußere Mantelrohr eine in der axiallen Richtung verlaufende Strukturierung auf, die in einer Umfangsrichtung abwechselnd Querschnittsverengungen und Querschnittserweiterungen in dem Zwischenraum bildet. Die Querschnittserweiterungen bilden jeweils einen Strömungspfad. Insbesondere ist die Strukturierung wellenförmig, bevorzugt eine sinuswellenartige Strukturierung. Insbesondere wird durch die Querschnittsverengungen keine Trennung der einzelnen Strömungspfade erreicht, so dass ein (begrenzter) Austausch des Fluids zwischen in Umfangsrichtung benachbarten Strömungspfaden möglich ist. Eine zumindest teilweise Trennung der Strömungspfade durch die Querschnittsverengungen ist aber ebenso erfindungsgemäß.

Insbesondere sind das innere Mantelrohr und das äußere Mantelrohr mit einer Strukturierung versehen, wobei diese Strukturierungen zueinander derart ausgerichtet sind, dass sich entlang einer Umfangsrichtung jeweils beide Mantelrohre einander annähern oder voneinander entfernen, so dass Querschnittsverengungen und Querschnittserweiterungen ausgebildet werden. Insbesondere beträgt das Verhältnis der größten Weite der Querschnittserweiterung zu der kleinsten Weite der Querschnittsverengung (größte Weite / kleinste Weite) einen Wert von mindestens 2, bevorzugt von mindestens 3, besonders bevorzugt von mindestens 5.

Insbesondere ist das äußere Mantelrohr und/oder das innere Mantelrohr mit einem (geringsten) Abstand von 2 bis 7 mm [Millimeter] zu einer Außenfläche eines Wärmetauscherrohrs angeordnet. Durch diesen Abstand ergibt sich eine vorteilhafte Aufteilung des Fluidstroms über die verfügbare Außenfläche der Wärmetauscherrohre. Durch die Strukturierung des äußeren Mantelrohres und/oder des inneren Mantelrohres wird insbesondere erreicht, dass das Abgas nah an den Wärmetauscherrohren vorbeigeführt wird. Insbesondere weisen die Wärmetauscherrohre einen größten Durchmesser von 25 bis 35 mm [Millimeter] auf, insbesondere bis höchstens 30 mm. Insbesondere sind die Wärmetauscherrohre mit einer Distanz der Außenflächen in Umfangsrichtung von 4 bis 14 mm [Millimeter] voneinander beabstandet.

Insbesondere sind zumindest auf einem Wärmetauscherrohr und/oder zumindest in einem Strömungspfad Leitelemente angeordnet, die eine Umlenkung des Fluids/ Abgases bewirken können. Die Leitelemente sind insbesondere zumindest teilweise an dem inneren und/oder an dem äußeren Mantelrohr befestigt. Diese Leitelemente dienen insbesondere dazu das Fluid um das Wärmetauscherrohr herum zu lenken und/oder das Fluid zwischen benachbarten Wärmetauscherrohren zu mischen und/oder das Fluid zumindest teilweise zu einem benachbarten Wärmetauscherrohr umzulenken.

Gemäß einer weiteren Ausgestaltung ist zumindest ein Wärmetauscherrohr und/oder ein zumindest ein Leitelement und/oder das innere Mantelrohr und/oder das äußere Mantelrohr mit Strukturen zur Erzeugung von Turbulenzen in der Fluidströmung ausgestattet. Diese Strukturen können durch eine erhöhte Rauhigkeit und/oder durch Mikrostrukturen gebildet sein. Diese Strukturen erzeugen Turbulenzen innerhalb des Fluidstroms um das Wärmetauscherrohr, so dass ein Wärmeübergang vom Fluidstrom zum Wärmetauscherrohr verbessert wird. Damit wird dem Fluidstrom ein erhöhter Anteil an Wärmeenergie entzogen und über die Wärmetauscherrohre abgeführt. Damit ist ein effizienterer Einsatz des Wärmetauschers bzw. des thermoelektrischen Generators hier möglich. Insbesondere weisen alle Wärmetauscherrohre und/oder Leitelemente solche Strukturen auf.

Die Strukturen erzeugen Turbulenzen innerhalb des Fluidstroms um das Wärmetauscherrohr, so dass ein Wärmeübergang vom Fluidstrom zum Wärmetauscherrohr verbessert wird. Damit wird dem Fluidstrom ein erhöhter Anteil an Wärmeenergie entzogen und über die Wärmetauscherrohre abgeführt. Damit ist ein effizienterer Einsatz des Wärmetauschers bzw. des thermoelektrischen Generators hier möglich.

Insbesondere sind die Strukturen am Wärmetauscherrohr und am Leitelement und an dem inneren sowie äußeren Mantelrohr angeordnet und hinsichtlich ihrer Positionierung und strömungstechnischen Wirkung aufeinander abgestimmt.

Insbesondere sind die Mikrostrukturen in der Form von Noppen und/oder Dellen ausgeführt. Die Noppen erstrecken sich ausgehend von der Oberfläche des Leitelements/ Wärmetauscherrohrs / Mantelrohrs nach außen, die Dellen erstrecken sich nach innen.

Insbesondere werden die Strukturen durch eine erhöhte Rauheit gebildet. Die Rauheit der Oberfläche des Wärmetauscherrohrs, die dem Fluidstrom zugewandt ist, ist dabei erhöht gegenüber der Rauheit an der Oberfläche des Wärmetauscherrohrs, die den thermoelektrischen Elementen oder dem Kühlfluid zugewandt ist. Die Rauheit der Oberfläche des inneren und/oder äußeren Mantelrohrs, die den Wärmetauscherrohren zugewandt ist, ist dabei erhöht gegenüber der Rauheit an der Oberfläche des inneren und/oder äußeren Mantelrohrs, die den Wärmetauscherrohren abgewandt ist. Insbesondere ist die erhöhte Rauheit an den Wärmetauscherrohren und/oder dem inneren und/oder dem äußeren Mantelrohr um einen Faktor von mindestens 5 erhöht, bevorzugt von mindestens 10 und besonders bevorzugt von mindestens 20. Die Rauheit wird als mittlere Rauheit Ra oder gemittelte Rautiefe Rz ermittelt. Die Verfahren zur Ermittlung der Rauheits-Kennwerte sind dem Fachmann aus internationalen Normen bekannt, z. B. aus der DIN EN ISO 4287.
Insbesondere weist der Bypass keine Strukturen zur Erhöhung der Turbulenz auf. Insbesondere weist der Bypass auch keine Leitelemente auf.

Gemäß einer weiteren vorteilhaften Ausgestaltung erstrecken sich die Wärmetauscherrohre in axialer Richtung über den ersten Kanal und/oder über den zweiten Kanal hinaus. Die Wärmetauscherrohre sind über zumindest einen (gemeinsamen) Anschluss mit einer Kühlmittelversorgung verbunden. Der Anschluss umfasst insbesondere einen Zulauf und einen Rücklauf, so dass ein Kühlfluid zwischen den Wärmetauscherrohren und einer Kühlmitteleinrichtung zirkulieren kann. Insbesondere sind die Wärmetauscherrohre an mindestens einer gemeinsamen Verschlussplatte angeordnet, die die Verteilung des Kühlfluids von einem Anschluss an die einzelnen Wärmetauscherrohre ermöglicht. Dabei kann auch jeweils eine Verschlussplatte an der ersten Stirnseite und an der zweiten Stirnseite angeordnet sein, so dass alle Wärmetauscherrohre in einer axialen Richtung von dem Kühlfluid durchströmt werden.

Insbesondere kann bei dem Wärmetauscher innerhalb des ersten Kanals ein von dem Fluid radial durchströmbarer Wabenkörper angeordnet werden. Dieser ist insbesondere katalytisch beschichtet. Der Wabenkörper weist einen zentrisch angeordneten Einströmkanal auf, der zum Einlass hin offen ausgeführt ist. Das Fluid strömt folglich über den Einlass in den Einströmkanal ein und wird durch die radial verlaufenden Strömungskanäle des Wabenkörpers in den Zwischenraum weitergeleitet.

Die Erfindung findet insbesondere Anwendung bei einem Kraftfahrzeug mit einer Verbrennungskraftmaschine und einer Abgasbehandlungsvorrichtung sowie einer in der Abgasleitung angeordneten erfindungsgemäßen Vorrichtung, wobei das Fluid ein Abgas der Verbrennungskraftmaschine ist. Insbesondere können natürlich mehrere Vorrichtungen in einer einsträngigen oder auch mehrsträngigen Abgasleitung vorgesehen sein.

Die Vorrichtung kann auch nachträglich in eine Abgasleitung eingebaut werden, wobei lediglich ein Anschluss an eine Kühlmittelversorgung erfolgen muss. Gegebenenfalls ist auch ein Anschluss an eine Regeleinheit erforderlich, um einen vorgesehenen Bypass entsprechend anzusteuern.

Die Erfindung sowie das technische Umfeld werden nachfolgend anhand der Figuren näher erläutert. Die Figuren zeigen besonders bevorzugte Ausführungsbeispiele, auf die die Erfindung jedoch nicht begrenzt ist. Es zeigen schematisch:
- Fig. 1:: eine Vorrichtung mit einem Wärmetauscher im Längsschnitt;
- Fig. 2:: eine weitere Ausführungsvariante einer Vorrichtung mit einem Wärmetauscher im Längsschnitt;
- Fig. 3:: die Vorrichtung aus Fig. 1 im Querschnitt; und
- Fig. 4:: eine beispielhafte Anordnung einer solchen Vorrichtung in einem Kraftfahrzeug.

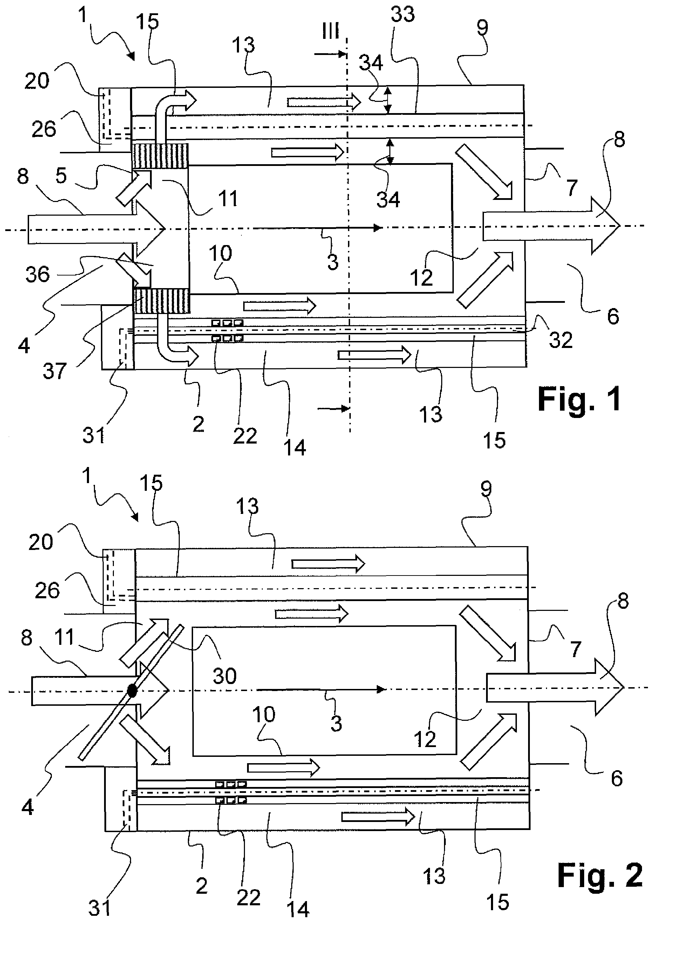

Fig. 1 zeigt eine Vorrichtung mit einem Wärmetauscher 1 in einem Längsschnitt. Das Fluid 8 (bzw. Abgas) strömt durch den Einlass 4 an der ersten Stirnseite 5 und durch den strömungstechnisch mit dem Einlass 4 verbundenen Einströmkanal 36 in den radial durchströmbaren Wabenkörper 37. Der Wabenkörper 37 ist in dem ringförmigen ersten Kanal 11 angeordnet. Das Fluid 8 durchströmt den radial durchströmbaren Wabenkörper 37 in radialer Richtung und tritt in den Zwischenraum 14 ein, der vom äußeren Mantelrohr 9 und vom inneren Mantelrohr 10 gebildet wird. In dem Zwischenraum 14 wird das Fluid 8 erneut umgelenkt in die axiale Richtung 3 und strömt durch den Zwischenraum 14 in Richtung des Auslasses 6. In dieser Fig. 1 ist der Zwischenraum 14 in der axialen Richtung 3 zylindrisch ausgeführt. Eine konische Ausführung ist entsprechend auch möglich, z. B. indem sich der Zwischenraum 14 entlang der axialen Richtung 3 erweitert.

Das Fluid 8 strömt entlang einer Vielzahl von Strömungspfaden 13, die um die Wärmetauscherrohre 15 ausgebildet sind, in der axialen Richtung 3 zu dem zweiten Kanal 12. Durch den zweiten Kanal 12 wird das Fluid 8 gesammelt und zum Auslass 6 an der zweiten Stirnseite 7 weitergeleitet. Die Wärmetauscherrohre 15 erstrecken sich durch den gesamten Zwischenraum 14 in der axialen Richtung 3. Die Wärmetauscherrohre 15 werden über ihre Außenfläche 33 von dem Fluid 8 überströmt. Hier bildet sich also die "Warmseite" aus. Die Wärmetauscherrohre 15 weisen einen inneren Kanal 32 auf, durch den sie von einem Kühlfluid 31 durchströmt werden. Zwischen dem inneren Kanal 32 ("Kaltseite") und der Außenfläche 33 ("Warmseite") sind thermoelektrische Elemente 22 angeordnet, die insbesondere ringförmig sind. Die Vorrichtung mit den thermoelektrischen Elementen 22 bildet einen thermoelektrischen Generator. Das heiße Fluid 8 (Abgas) umströmt die Außenfläche 33 der Wärmetauscherrohre 15, so dass ein Temperaturpotential zwischen Kaltseite und Warmseite ausgebildet wird. Dieses Temperaturpotential wird durch die thermoelektrischen Elemente 22 in elektrische Energie umgewandelt.

Die Wärmetauscherrohre 15 sind in den Strömungspfaden 13 angeordnet, die durch das innere Mantelrohr 10 und das äußere Mantelrohr 9 jeweils gebildet werden. Hier bildet das äußere Mantelrohr 9 zumindest teilweise das Gehäuse 2. Das äußere Mantelrohr 9 und das innere Mantelrohr 10 sind jeweils in einem Abstand 34 zur Außenfläche 33 des Wärmetauscherrohrs 15 angeordnet.

Im Bereich des Einlasses 4 bzw. der ersten Stirnseite 5 ist am Gehäuse 2 eine Verschlussplatte 26 vorgesehen. Diese dient einerseits zur Begrenzung des Zwischenraums 14 in der axialen Richtung 3 und andererseits zur Aufnahme der Wärmetauscherrohre 15, so dass hier ein das Wärmetauscherrohr 15 durchströmendes Kühlfluid 31 zu- und abgeführt wird. In der Verschlussplatte 26 ist ein Anschluss 20 angeordnet zur Anbindung an eine Kühlmittelversorgung. Die Wärmetauscherrohre 15 erstrecken sich ausgehend von der Verschlussplatte 26 durch den Zwischenraum 14 hin bis zur zweiten Stirnseite 7. Dort ist eine Umlenkung vorgesehen durch die das Kühlfluid 31 durch ein weiteres Wärmetauscherrohr 15 zur Verschlussplatte 26 zurückgeführt wird. Gleichzeitig können in der Verschlussplatte 26 elektrische Anschlüsse (nicht gezeigt) vorgesehen sein, so dass ein infolge des Temperaturunterschieds zwischen heißem Fluid 8 und kaltem Kühlfluid 31 innerhalb der Wärmetauscherrohre 15 erzeugter elektrischer Strom, infolge der Anordnung von thermoelektrischen Elementen 22 innerhalb der Wärmetauscherrohre 15, zum Kraftfahrzeug abgeführt werden kann.

Fig. 2 zeigt eine weitere Ausführungsvariante einer Vorrichtung mit einem Wärmetauscher 1 in einem Längsschnitt. Für gleiche Gegenstände in den Figuren gelten gleiche Bezugszeichen. Im Bereich des Einlass 4 ist ein Regelelement 30 angedeutet, dass den Fluidstrom in einen Bypass umlenken kann. Ein Bypass wird durch einen Strömungspfad 13 gebildet, in dem kein Wärmetauscherrohr 15 angeordnet ist (hier nicht gezeigt).

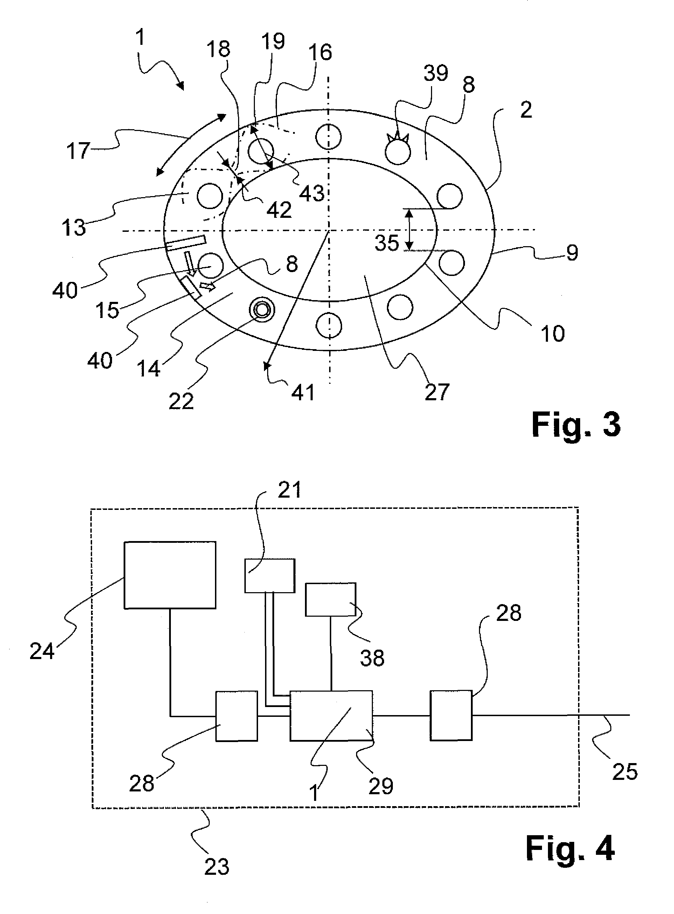

Fig. 3 zeigt die Vorrichtung mit Wärmetauscher 1 gemäß Fig. 1 im Querschnitt entlang der in Fig. 1 gezeigten Schnittachse (III). Das Gehäuse 2 wird hier durch das äußere Mantelrohr 9 gebildet und umschließt den Zwischenraum 14 und das innere Mantelrohr 10. In dem Zwischenraum 14 sind Wärmetauscherrohre 15 angeordnet. Der Zwischenraum 14 ist ringförmig und wird nach innen von dem inneren Mantelrohr 10 begrenzt. Das innere Mantelrohr 10 umschließt einen Hohlraum 27. In dem Zwischenraum 14 sind eine Vielzahl von Strömungspfaden 13 ausgebildet, entlang derer das Fluid 8 den Zwischenraum 14 durchströmen kann. An einem Wärmetauscherrohr 15 sind Strukturen 39 gezeigt, die zur Turbulenzerzeugung im Fluidstrom dienen. Durch diese Strukturen 39 kann der Wärmeübergang zwischen Fluid 8 und Wärmetauscherrohren 15 verbessert werden.

Im unteren Teil der Fig. 3 ist ein Wärmetauscherrohr 15 im Querschnitt im Detail dargestellt, wobei hier die ringförmigen thermoelektrischen Elemente 22 innerhalb des Wärmetauscherrohrs 15 gezeigt sind. Die Wärmetauscherrohre 15 sind in Umfangsrichtung 17 in einer Distanz 35 zueinander angeordnet.

In der linken oberen Hälfte der Fig. 3 ist eine Strukturierung 16 des äußeren Mantelrohrs 9 und des inneren Mantelrohrs 10 angedeutet (gestrichelte Linie). Durch die Strukturierung 16 werden Querschnittsverengungen 18 und Querschnittserweiterungen 19 im Zwischenraum 14 in Umfangsrichtung 17 gebildet. Durch die hier gezeigten Querschnittsverengungen 18 ist ein Austausch von Fluid 8 in Umfangsrichtung 17 zwischen Strömungspfaden 13 in benachbarten Querschnittserweiterungen 19 möglich. Die engste Stelle der Querschnittsverengung 18 weist eine kleinste Weite 42 auf. Die weiteste Stelle der Querschnittserweiterung 19 weist eine größte Weite 43 auf.

In Fig. 3 sind zudem Leitelemente 40 gezeigt, die das Fluid 8 zumindest teilweise umlenken. Durch die Leitelemente 40 wird das Fluid 8 um die einzelnen Wärmetauscherrohre 15 herumgeführt, so dass das Fluid 8 nicht nur in der axialen Richtung 3, sondern zumindest teilweise auch in einer Umfangsrichtung 17 und/oder in einer radialen Richtung 41 strömt.

Fig. 4 zeigt die Anordnung der Vorrichtung mit Wärmetauscher 1 innerhalb eines Kraftfahrzeugs 23. Das Kraftfahrzeug 23 weist eine Verbrennungskraftmaschine 24 mit einer Abgasleitung 25 sowie weiteren Abgasbehandlungskomponenten 28 auf. Der Wärmetauscher 1 ist hier als thermoelektrischer Generator 29 ausgeführt, wobei die in dem thermoelektrischen Generator 29 angeordneten Wärmetauscherrohre über einen Zulauf und einen Rücklauf mit einer Kühlmittelversorgung 21 verbunden sind. Weiterhin ist eine Regeleinheit 38 vorgesehen, die unter anderem zur Ansteuerung des Regelelements innerhalb des Wärmetauschers 1 dient, so dass die Abgasmenge, die über den Bypass strömt, gesteuert werden kann. Damit kann das Abgas an den Wärmetauscherrohren und den thermoelektrischen Elementen vorbeigeführt werden, so dass die Kühlmittelversorgung 21 der Verbrennungskraftmaschine 24 ggf. nicht durch das Abgas im thermoelektrischen Generator 29 zusätzlich beaufschlagt wird.

Andere Ausgestaltungen bzw. Ausführungsvarianten der Erfindung sind möglich. Insbesondere ist es möglich, dass mehrere Verschlussplatten 26 innerhalb des Gehäuses 2 angeordnet sind, so dass die Wärmetauscherrohre 15 nicht nur an einem Ende sondern auch an einem weiteren Ende aufgenommen werden. So können auch Anschlüsse 20 jeweils in getrennten Verschlussplatten 26 angeordnet werden, so dass die Durchströmung der Wärmetauscherrohre 15 lediglich in einer axialen Richtung 3 erfolgt. In den hier gezeigten Figuren durchströmt ein Kühlfluid 31 die Wärmetauscherrohre 15 ausgehend von der Verschlussplatte 26 in der Nähe des Einlass 4 in einer axialen Richtung 3 bis zur zweiten Stirnseite 7 und zurück hin zur Verschlussplatte 26. Insbesondere kann die Verschlussplatte 26 auch an der zweiten Stirnseite 7 der Vorrichtung angeordnet werden.

Es ist ebenfalls erfindungsgemäß einen Bypass für das Fluid 8 mit dem Hohlraum 27 zu bilden. Dieser ist dann zum Einlass 4 bzw. zum Auslass 6 hin offen ausgeführt, so dass der Hohlraum 27 von dem Fluid 8 durchströmt werden kann. Der Bypass kann dann insbesondere durch eine Klappe als Regelelement 30 gebildet werden, die innerhalb von dem Hohlraum 27 angeordnet ist. Durch die Öffnung der Klappe wird zumindest ein Großteil des Fluid 8 durch den Hohlraum 27 geleitet, da hier der geringste Strömungswiderstand vorherrscht (gegenüber einer Durchleitung des Fluid durch die Strömungspfade 13). In diesem Fall ist das innere Mantelrohr 10 zumindest teilweise insbesondere ohne Strukturierung 16 ausgeführt, so dass das Regelelement 30 den Hohlraum 27 an dem inneren Mantelrohr 10 dicht verschließen kann.

### Bezugszeichenliste

- 1: Wärmetauscher
- 2: Gehäuse
- 3: Axiale Richtung
- 4: Einlass
- 5: Erste Stirnseite
- 6: Auslass
- 7: Zweite Stirnseite
- 8: Fluid
- 9: Äußeres Mantelrohr
- 10: Inneres Mantelrohr
- 11: Erster Kanal
- 12: Zweiter Kanal
- 13: Strömungspfad
- 14: Zwischenraum
- 15: Wärmetauscherrohr
- 16: Strukturierung
- 17: Umfangsrichtung
- 18: Querschnittsverengung
- 19: Querschnittserweiterung
- 20: Anschluss
- 21: Kühlmittelversorgung
- 22: Thermoelektrische Elemente
- 23: Kraftfahrzeug
- 24: Verbrennungskraftmaschine
- 25: Abgasleitung
- 26: Verschlussplatte
- 27: Hohlraum
- 28: Abgasbehandlungskomponente
- 29: Thermoelektrischer Generator
- 30: Regelelement
- 31: Kühlfluid
- 32: Innerer Kanal
- 33: Außenfläche
- 34: Abstand
- 35: Distanz
- 36: Einströmkanal
- 37: Wabenkörper
- 38: Regeleinheit
- 39: Struktur
- 40: Leitelement
- 41: Radiale Richtung
- 42: Kleinste Weite
- 43: Größte Weite

## Patentansprüche

1. Vorrichtung mit einem Wärmetauscher (1), zumindest aufweisend ein Gehäuse (2) mit entlang einer axialen Richtung (3) angeordnetem Einlass (4) an einer ersten Stirnseite (5) und einem Auslass (6) an einer zweiten Stirnseite (7) für ein Fluid (8), sowie zumindest ein äußeres Mantelrohr (9) und ein konzentrisch dazu angeordnetes inneres Mantelrohr (10), wobei das Gehäuse (2) weiter ein sich an den Einlass (4) anschließenden ringförmigen ersten Kanal (11) und einen stromaufwärts von dem Auslass (6) angeordneten ringförmigen zweiten Kanal (12) aufweist, wobei der erste Kanal (11) und der zweite Kanal (12) durch eine Vielzahl von Strömungspfaden (13) für das Fluid (8) verbunden sind, die sich in einem Zwischenraum (14) zwischen dem inneren Mantelrohr (10) und dem äußeren Mantelrohr (9) in der axialen Richtung (3) erstrecken, wobei in der Vielzahl von Strömungspfaden (13) jeweils mindestens ein Wärmetauscherrohr (15) angeordnet ist, wobei das Fluid (8) über den Einlass (4) in den ringförmigen ersten Kanal (11) einströmt und anschließend über die Vielzahl von Strömungspfaden (13) hin zum ringförmigen zweiten Kanal (12) geführt wird und das Gehäuse (2) über den Auslass (6) verlässt; **dadurch gekennzeichnet, dass** das innere Mantelrohr (10) und/oder das äußere Mantelrohr (9) eine in der axialen Richtung (3) verlaufende Strukturierung (16) aufweist, die in Umfangsrichtung (17) abwechselnd Querschnittsverengungen (18) und Querschnittserweiterungen (19) in dem Zwischenraum (14) bildet, wobei die Querschnittserweiterungen (19) jeweils einen Strömungspfad (13) bilden.

2. Vorrichtung nach Anspruch 1, wobei sich die Wärmetauscherrohre (15) in axialer Richtung (3) über den ersten Kanal (11) und/oder über den zweiten Kanal (12) hinaus erstrecken und außerhalb des Gehäuses (2) über zumindest einen Anschluss (20) mit einer Kühlmittelversorgung (21) verbunden sind.

3. Vorrichtung nach einem der vorhergehenden Patentansprüche, wobei thermoelektrische Elemente (22) in den Wärmetauscherrohren (15) angeordnet sind.

4. Vorrichtung nach einem der vorhergehenden Patentansprüche, wobei Leitelemente (40) zur Umlenkung des Fluid (8) in den Strömungspfaden (13) vorgesehen sind.

5. Kraftfahrzeug (23), aufweisend eine Verbrennungskraftmaschine (24) und eine Abgasleitung (25) und eine in der Abgasleitung (25) angeordnete Vorrichtung nach einem der vorhergehenden Patentansprüche, wobei das Fluid (8) ein Abgas der Verbrennungskraftmaschine (24) ist.

## Claims

1. Device with a heat exchanger (1), at least having a housing (2) with an inlet (4) arranged along an axial direction (3) at a first end side (5), and with an outlet (6) at a second end side (7), for a fluid (8), and having at least one outer shell tube (9) and an inner shell tube (10) arranged concentrically with respect thereto, wherein the housing (2) also has an annular first duct (11) which adjoins the inlet (4) and an annular second duct (12) arranged upstream of the outlet (6), wherein the first duct (11) and the second duct (12) are connected by a multiplicity of flow paths (13) for the fluid (8) which extend in the axial direction (3) in an intermediate space (14) between the inner shell tube (10) and the outer shell tube (9), wherein in each case at least one heat exchanger tube (15) is arranged in the multiplicity of flow paths (13), wherein the fluid (8) flows into the annular first duct (11) via the inlet (4), is subsequently conducted via the multiplicity of flow paths (13) to the annular second duct (12), and exits the housing (2) via the outlet (6); **characterized in that** the inner shell tube (10) and/or the outer shell tube (9) has a structuring (16) which runs in the axial direction (3) and which, in the circumferential direction (17), alternately forms cross-sectional narrowings (18) and cross-sectional widenings (19) in the intermediate space (14), wherein the cross-sectional widenings (19) form in each case one flow path (13).

2. Device according to Claim 1, wherein the heat exchanger tubes (15) extend in the axial direction (3) beyond the first duct (11) and/or beyond the second duct (12) and, outside the housing (2), are connected via at least one port (20) to a coolant supply (21).

3. Device according to one of the preceding patent claims, wherein thermoelectric elements (22) are arranged in the heat exchanger tubes (15).

4. Device according to one of the preceding patent claims, wherein guide elements (40) for diverting the fluid (8) are provided in the flow paths (13).

5. Motor vehicle (23) having an internal combustion engine (24) and having an exhaust line (25) and a device according to one of the preceding claims arranged in the exhaust line (25), wherein the fluid (8) is an exhaust gas of the internal combustion engine (24).

## Revendications

1. Dispositif comprenant un échangeur de chaleur (1), présentant au moins un boîtier (2) avec une entrée (4) disposée le long d'une direction axiale (3) au niveau d'un premier côté frontal (5) et une sortie (6) au niveau d'un deuxième côté frontal (7) pour un fluide (8), ainsi qu'au moins un tube d'enveloppe extérieur (9) et un tube d'enveloppe intérieur (10) disposé concentriquement à celui-ci, le boîtier (2) présentant en outre un premier canal annulaire (11) se raccordant à l'entrée (4) et un deuxième canal annulaire (12) disposé en amont de la sortie (6), le premier canal (11) et le deuxième canal (12) étant connectés par une pluralité de chemins d'écoulement (13) pour le fluide (8), qui s'étendent dans un espace intermédiaire (14) entre le tube d'enveloppe intérieur (10) et le tube d'enveloppe extérieur (9) dans la direction axiale (3), à chaque fois au moins un tube d'échangeur de chaleur (15) étant disposé dans la pluralité de chemins d'écoulement (13), le fluide (8) affluant par le biais de l'entrée (4) dans le premier canal annulaire (11) et étant ensuite guidé par le biais de la pluralité de chemins d'écoulement (13) vers le deuxième canal annulaire (12) et quittant le boîtier (2) par le biais de la sortie (6) ; **caractérisé en ce que** le tube d'enveloppe intérieur (10) et/ou le tube d'enveloppe extérieur (9) présentent une structuration (16) s'étendant dans la direction axiale (3), qui forme des rétrécissements de section transversale (18) et des élargissements de section transversale (19) alternant dans la direction périphérique (17) dans l'espace intermédiaire (14), les élargissements de section transversale (19) formant à chaque fois un chemin d'écoulement (13).

2. Dispositif selon la revendication 1, dans lequel les tubes d'échangeur de chaleur (15) s'étendent dans la direction axiale (3) au-delà du premier canal (11) et/ou au-delà du deuxième canal (12) et sont connectés à l'extérieur du boîtier (2) à une alimentation en réfrigérant (21) par le biais d'au moins un raccord (20).

3. Dispositif selon l'une quelconque des revendications précédentes, dans lequel des éléments thermoélectriques (22) sont disposés dans les tubes d'échangeur de chaleur (15).

4. Dispositif selon l'une quelconque des revendications précédentes, dans lequel des éléments directeurs (40) sont prévus pour dévier le fluide (8) dans les chemins d'écoulement (13).

5. Véhicule automobile (23), présentant un moteur à combustion interne (24) et une conduite de gaz d'échappement (25) et un dispositif disposé dans la conduite de gaz d'échappement (25) selon l'une quelconque des revendications précédentes, le fluide (8) étant un gaz d'échappement du moteur à combustion interne (24).
